# EUROPEAN PATENT APPLICATION

(11) **EP 4 325 589 A1**
(43) Date of publication of application: **21.02.2024**
(21) Application number: 22788305.5
(22) Date of filing: 29.03.2022
(51) Int. Cl.: H01L 51/42, H01L 51/44, H01L 51/00

(54) **PEROVSKITE SOLAR CELL AND MANUFACTURING METHOD THEREFOR**

(30) Priority: 13.04.2021 KR 20210047651
(71) Applicant: Hanwha Solutions Corporation, Jung-gu Seoul 04541 (KR)
(72) Inventor: YEOM, Eun Joo, Guri-si, Gyeonggi-do 11919 (KR)
(74) Representative: Mooser, Sebastian Thomas
(86) International application number: PCT/KR2022/004432
(87) International publication number: WO 2022/220449

(57) **Abstract**

The present invention relates to a perovskite solar cell and a method for manufacturing the same, and relates to a perovskite solar cell and a method for manufacturing the same, the perovskite solar cell comprising an electron transporting layer formed of specific components, and a passivation layer introduced between the electron transporting layer and a source electrode.

## Description

### TECHNICAL FIELD

The present invention relates to a perovskite solar cell having an electron transporting layer formed of specific components, and a conductive barrier layer introduced between the electron transport layer and a source electrode, and a method for manufacturing the same.

### BACKGROUND

In order to solve the global environmental problems caused by the depletion of fossil energy and its use, research on renewable and clean alternative energy sources such as solar energy, wind power, and hydroelectric power is being actively conducted.

Among them, interest in solar cells that convert sunlight directly into electrical energy is greatly increasing. Here, the solar cell refers to a cell that generates current-voltage using the photovoltaic effect of generating electrons and holes by absorbing light energy from sunlight.

Currently, it is possible to manufacture n-p diode-type silicon (Si) single crystal-based solar cells with a light energy conversion efficiency of over 20% and it is used in actual solar power generation, and there is also a solar cell using a compound semiconductor such as gallium arsenide (GaAs), which has a higher conversion efficiency than this. However, since these inorganic semiconductor-based solar cells require highly purified materials for high efficiency, a lot of energy is consumed in refining raw materials, and also, expensive process equipment is required in the process of single crystal or thin film using raw materials, so there is a limit to lowering the manufacturing cost of solar cells, which has been an obstacle to large-scale utilization.

Accordingly, in order to manufacture a solar cell at low costs, a cost of a material used as a core for a solar cell or a manufacturing process needs to be greatly reduced, and as an alternative to an inorganic semiconductor-based solar cell, research on a perovskite solar cell that can be manufactured by a low-cost material and process has been conducted.

Recently, a perovskite solar cell using (NH₃CH₃)PbX₃ (X=I, Br, Cl) which is a halogen compound having a perovskite structure as a photoactive material has been developed, and research on commercialization has been conducted. The general structural formula of the perovskite structure is an ABX₃ structure, where an anion is located at the X position, a large cation is located at the A position, and a small cation is located at the B position.

The perovskite solar cell, which is an organometallic halogen compound of the molecular formula (CH₃NH₃)PbX₃, was first used as a photoactive material of a solar cell in 2009. Since the solid-type perovskite solar cell having the structure as present in 2012 has been developed, efficiency has been rapidly improved. Typical perovskite solar cells use a metal oxide as an electron transporting layer and mainly use an organic material or a polymer material such as spiro-OMETAD as a hole transport layer (HTL). That is, a metal oxide porous film or thin film is manufactured on a transparent electrode such as FTO, and a perovskite material is coated, and then, a hole transport layer is coated, and an electrode layer such as gold (Au) or silver (Ag) is deposited.

An important task for commercialization of a perovskite solar cell is stability securing and flexible technology, and the existing electron transporting layer formed using a metal oxide on the photoactive layer has a metal oxide deposition layer or a metal oxide coating layer on the photoactive layer (or the light absorption layer), and then a separate organic binder coating layer is formed thereon. However, there are disadvantages in that when a metal oxide is deposited and formed, a manufacturing process is complicated to greatly increase manufacturing costs, and a light absorption layer may be damaged due to physical and chemical energy generated during the deposition process. In addition, in the method of forming the organic binder coating layer, there is a problem in that high-temperature heat treatment is performed to form the coating layer, but the perovskite material is decomposed at a high temperature of 200 °C or higher, and there is a problem of reducing the flexibility of the solar cell and narrowing the application range of the perovskite solar cell.

In addition, generally, when manufacturing perovskite heterojunction solar cells, fullerene (C₆₀) is formed as a conductive barrier layer through deposition in order to form an electron transporting layer without damaging the light absorption layer, but there is a problem in that fullerene has a high absorbance, causing unnecessary parasitic absorption, which reduces the efficiency of solar cells, such as the short-circuit current density (J_{sc}).

### SUMMARY OF THE INVENTION

### Technical Problem

The present invention has been devised in an effort to solve the problems described above, and is directed to providing a perovskite solar cell that secures high efficiency by forming a conductive barrier layer between a source electrode and an electron transporting layer formed of a specific material without forming a fullerene deposition layer that reduces the Jsc of the solar cell; and a manufacturing method thereof.

### Technical Solution

In order to solve the above problems, the perovskite solar cell of the present invention may include a structure in which a hole transport layer, a perovskite light absorption layer, an electron transporting layer, and a source electrode are sequentially stacked, and a conductive barrier layer may be formed between the source electrode and the electron transporting layer.

In a preferred embodiment of the present invention, the electron transporting layer may include surface-modified SnO₂ nanoparticles.

In a preferred embodiment of the present invention, the electron transporting layer may have an average thickness of 100 nm or less.

In a preferred embodiment of the present invention, the electron transporting layer may have a light transmittance of 88 to 95% for a wavelength of 500 to 550 nm when the electron transporting layer has a thickness of 20 to 30 nm.

In a preferred embodiment of the present invention, the surface of the electron transporting layer may have a root-mean-square (RMS) roughness of 25 nm or less.

In a preferred embodiment of the present invention, the conductive barrier layer may be a transparent thin film deposited with ITO (indium tin oxide), FTO (fluorine doped tin oxide), ATO (Sb₂O₃ doped tin oxide), GTO (gallium doped tin oxide), ZTO (tin doped zinc oxide), ZTO:Ga (gallium doped ZTO), IGZO (indium gallium zinc oxide), IZO (indium doped zinc oxide), or AZO (aluminum doped zinc oxide).

In a preferred embodiment of the present invention, the conductive barrier layer may have an average thickness of 50 to 110 nm.

In a preferred embodiment of the present invention, the surface of the conductive barrier layer may have an RMS roughness of 30 nm or less.

In a preferred embodiment of the present invention, the conductive barrier layer may have a sheet resistance of 80 Ω/sq.

In a preferred embodiment of the present invention, the perovskite solar cell of the present invention may be a fin-structure perovskite solar cell, an inverted-structure perovskite solar cell, a tandem-type perovskite solar cell, or a tandem-type silicon/perovskite heterojunction solar cell.

In a preferred embodiment of the present invention, if the perovskite solar cell of the present invention is an inverted-structure perovskite solar cell, it may have a structure in which a drain electrode, a hole transport layer, a perovskite light absorption layer, an electron transporting layer, a conductive barrier layer, and a source electrode are sequentially stacked.

In a preferred embodiment of the present invention, if the perovskite solar cell of the present invention is a tandem-type silicon/perovskite heterojunction solar cell, it may have a structure in which a drain electrode, a silicon solar cell, a recombination layer, a hole transport layer, a perovskite light absorption layer, an electron transporting layer, a conductive barrier layer, and a source electrode are sequentially stacked.

Another aspect of the present invention relates to a method for manufacturing the perovskite solar cell described above, it may be manufactured by performing a process including: forming an electron transporting layer by coating a coating agent for forming an electron transporting layer on top of a perovskite light absorption layer of a laminate including a hole transport layer and a perovskite light absorption layer; forming a transparent thin film conduct ive barrier layer on top of the electron transporting layer through a deposition process; and forming a source electrode on top of the conductive barrier layer.

In a preferred embodiment of the present invention, the coating may be performed by a solution coating process, and the coating may be performed by a solution coating method such as spin coating, blade coating, or bar coating.

In a preferred embodiment of the present invention, the coating agent for forming an electron transporting layer may include 0.50 to 3.00% by weight of surface-modified metal oxide and a remaining amount of an organic solvent.

### Advantageous Effects

The perovskite solar cell of the present invention can form an electron transporting layer through a solution coating method using a coating agent for forming an electron transporting layer that can form an ultra-thin film through low-temperature heat treatment, and thus can prevent damage to the light absorption layer when forming the electron transporting layer, and can prevent a decrease in the photoelectric conversion efficiency of a solar cell by preventing electrode penetration and ion migration by a conductive barrier layer formed between the electron transporting layer and the source electrode, and the long-term performance stability of the solar cells is excellent.

### BRIEF DESCRIPTION OF THE DRAWINGS

FIG. 1 is a TEM measurement image of SnO₂ nanoparticles prepared in Example 1.
FIG. 2 is a XRD measurement graph of SnO₂ nanoparticles prepared in Example 1.
FIG. 3 is a FT-IR measurement graph of surface-modified SnO₂ nanoparticles prepared in Example 1.
FIG. 4(a) is a photograph of a solution in which unmodified SnO₂ nanoparticles are dispersed in isopropyl alcohol, and FIG. 4(b) is a photograph of a coating solution for forming an electron transporting layer prepared in Example 1.
FIG. 5 is a result of measuring a transmittance of a thin film prepared using the coating solution for forming an electron transporting layer of Example 1.
FIGS. 6A to 6B are SEM measurement images of the solar cells of Preparation Example 1 and Comparative Preparation Example 1, respectively.

### DETAILED DESCRIPTION OF THE EMBODIMENTS

Hereinafter, the present invention will be described in more detail.

Conventionally, perovskite solar cells used ultra-thin film layers such as fullerene (C₆₀), a double deposition layer of C₆₀ and SnO₂, and a thin film layer containing C₆₀ and SnO₂ as a conductive barrier layer in order to form an electron transporting layer without damaging the light absorption layer, but there was a problem in that fullerene has a high absorbance, causing unnecessary parasitic absorption, which reduces the short-circuit current density (J_{sc}) or the like of the solar cells.

Accordingly, the present invention relates to a perovskite solar cell that prevents degradation of photoelectric conversion efficiency and improves the long-term performance stability of the solar cell by preventing electrode penetration and ion migration, by excluding the fullerene (C₆₀) ultra-thin film layer, optimizing the electron transporting layer material, and forming a conductive barrier layer between the electron transporting layer and the source electrode.

The perovskite solar cell of the present invention may be a fin-structure perovskite solar cell, an inverted-structure perovskite solar cell, a tandem-type perovskite solar cell, or a tandem-type silicon/perovskite heterojunction solar cell, and is a solar cell including a laminate in which a hole transport layer (HTL), a perovskite light absorption layer, an electron transporting layer (ETL), a conductive barrier layer (passivation layer), and a source electrode are sequentially stacked.

In a preferred embodiment, if the solar cell of the present invention is an inverted-structure perovskite solar cell, the laminate may be stacked on top of a drain electrode.

In addition, the inverted-structure perovskite solar cell may be formed by sequentially stacking a conductive substrate, a drain electrode, a hole transport layer, a light absorption layer, an electron transporting layer, and a source electrode to form one set, and stacking the set in a single layer or multiple layers.

In another preferred embodiment, if the solar cell of the present invention is a tandem-type silicon/perovskite heterojunction solar cell, a drain electrode, a silicon solar cell, a recombination layer, and the above laminate may be sequentially stacked.

Describing in detail through a method of manufacturing the laminate constituting the perovskite solar cell of the present invention, the laminate may be manufactured by performing a process including: a first step of forming an electron transporting layer by coating a coating agent for forming an electron transporting layer on top of a perovskite light absorption layer of a laminate including a hole transport layer and a perovskite light absorption layer; a second step of forming a transparent thin film conductive barrier layer on top of the electron transporting layer through a deposition process; and a third step of forming a source electrode on top of the conductive barrier layer.

The hole transport layer (HTL) may include an inorganic and/or organic hole transport material. The inorganic hole transport material may include at least one selected from nickel oxide (NiOx), CuSCN, CuCrO₂, and CuI.

The organic hole transport material may include carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives, aromatic tertiary amine compounds, styrylamine compounds, aromatic dimethylidine-based compounds, porphyrin-based compounds, phthalocyanine-based compounds, polythiophene derivatives, polypyrrole derivatives, polyparaphenylenevinylene derivatives, pentacene, coumarin 6, 3-(2-benzothiazolyl)-7-(diethylamino)coumarin, ZnPC (zinc phthalocyanine), CuPC (copper phthalocyanine), TiOPC (titanium oxide phthalocyanine), Spiro-MeOTAD(2,2' ,7,7'-tetrakis(N,N-p-dimethoxyphenylamino)-9,9'-spirobifluor ene), F₁₆CuPC(copper(II) 1,2,3,4,8,9,10,11,15,16,17,18,22,23,24,25-hexadecafluoro-29H,31H-phthalocyani ne), SubPc(boron subphthalocyanine chloride) and N3(cis-di(thiocyanato)-bis(2,2'-bipyridyl-4,4'-dicarboxylic acid)-ruthenium(II), P3HT(poly[3-hexylthiophene]), MDMO-PPV(poly[2-methoxy-5-(3' ,7'-dimethyloctyloxyl)]-1,4-phenylene vinylene), MEH-PPV(poly[2-methoxy-5-(2''-ethylhexyloxy)-p-phenylene vinylene]), P3OT(poly(3-octyl thiophene)), POT(poly(octyl thiophene)), P3DT(poly(3-decyl thiophene)), P3DDT(poly(3-dodecyl thiophene), PPV(poly(p-phenylene vinylene)), TFB(poly(9,9'-dioctylfluorene-co-N-(4-butylphenyl)diphenyl amine), polyaniline, Spiro-MeOTAD([2,22',7,77'-tetrkis (N,N-di-pmethoxyphenyl amine)-9,9,9'-spirobi fluorine]), CuSCN, CuI, PCPDTBT(Poly[2,1,3-benzothiadiazole-4,7-diyl[4,4-bis(2-ethylhexyl-4H-cyclopen ta [2,1-b:3,4-b']dithiophene-2,6-diyl]], Si-PCPDTBT(poly[(4,4'-bis(2-ethylhexyl)dithieno[3,2-b:2' ,3'-d]silole)-2,6-diy l-alt-(2,1,3-benzothiadiazole)-4,7-diyl]), PBDTTPD(poly((4,8-diethylhexyloxyl), PFDTBT(poly[2,7-(9-(2-ethylhexyl)-9-hexyl-fluorene)-alt-5,5-(4', 7, di-2-thienyl-2',1', 3'-benzothiadiazole)]), PFO-DBT(poly[2,7-.9,9-(dioctyl-fluorene)-alt-5,5-(4',7'-di-2-.thienyl-2', 1', 3'-benzothiadiazole)]), PSiFDTBT(poly[(2,7-dioctylsilafluorene)-2,7-diyl-alt-(4,7-bis(2-thienyl)-2,1, 3-benzothiadiazole)-5,5'-diyl]), PCDTBT(Poly [[9-(1-octylnonyl)-9H-carbazole-2,7-diyl] -2,5-thiophenediyl-2,1,3-benzothiadiazole-4,7-diyl-2,5-thiophenediyl]), PFB(poly(9,9'-dioctylfluorene-co-bis(N,N'-(4,butylphenyl))bis(N,N'-phenyl-1,4 -phenylene)diamine), F8BT(poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, and/or MeO-2PACz.

Further, the method of forming the hole transport layer may include a coating method, a vacuum deposition method, and the like, and the coat ing method may include a gravure coat ing method, a bar coat ing method, a print ing method, a spraying method, a spin coating method, a dip coating method, a die coating method, and the like.

Next, the light absorption layer may include generally a perovskite mater ial appl ied to the light absorpt ion layer of the solar cell, and preferably, for example, may include a perovskite material represented by the following Formula 2.

[Formula 2] CMX₃

In Formula 2, C is a monovalent cation and may include an amine, an ammonium, a Group 1 metal, a Group 2 metal, and/or other cation or cation-like compounds, and preferably, formamidinium (FA), methylammonium (MA), FAMA, CsFAMA or N(R)₄⁺ (where R may be the same or different groups, and R is a linear alkyl group having 1 to 5 carbon atoms, a branched alkyl group having 3 to 5 carbon atoms, a phenyl group, an alkylphenyl group, an alkoxyphenyl group or an alkylhalide).

In addition, M of Formula 2 is a divalent cation and may include one or two selected from Fe, Co, Ni, Cu, Sn, Pb, Bi, Ge, Ti, Eu and Zr.

In addition, X of Formula 2 is a monovalent anion and may include at least one halide element selected from F, Cl, Br and I and/or a Group 16 anion, and as a preferred example, X may be IₓBr₃₋ₓ (0 ≤ x ≤ 3).

In addition, in a preferred embodiment, the Formula 2 may be, for example, FAPbIₓBr₃₋ₓ (0 ≤ x ≤ 3), MAPbIₓBr₃₋ₓ (0 ≤ x ≤ 3), CSMAFAPbIₓBr₃₋ₓ (0 ≤ x ≤ 3), CH₃NH₃PbX₃ (X= Cl, Br, I, BrI₂, or Br₂I), CH₃NH₃SnX₃ (X= Cl, Br or I), CH(=NH)NH₃PbX₃ (X= Cl, Br, I, BrI₂, or Br₂I), CH(=NH)NH₃SnX₃ (X= Cl, Br or I), and the like.

In the solar cell of the present invention, the light absorption layer may be a single layer formed of the same perovskite material or may be a multilayer structure in which a plurality of layers formed of different perovskite materials are stacked, and may include a different perovskite material different from the perovskite material having a pillar shape such as a column shape, a plate shape, a needle shape, a wire shape, and a rod shape in the light absorption layer formed of one perovskite material.

Next, the coating agent for forming the electron transporting layer is a dispersion of surface-modified metal oxide nanoparticles dispersed in an organic solvent, and contains 0.50 to 3.00% by weight of the surface-modified metal oxide and a balance of an organic solvent based on the total weight, preferably 0.58 to 2.88% by weight of the surface-modified metal oxide and a balance of an organic solvent, more preferably 0.65 to 1.91% by weight of the surface-modified metal oxide and a balance of an organic solvent.

In this case, if the content of the surface-modified metal oxide in the coating agent is less than 0.50 wt %, the content of the SnO₂ is not sufficient, and thus the light absorption layer may be exposed during the formation of the SnO₂ thin film, and if the content of the surface-modified metal oxide in the coating agent exceeds 3.00 wt %, the thickness of the SnO₂ thin film increases, and thus the short-circuit current (Jsc) and open-circuit voltage (Voc) values of the solar cell may decrease, and thus, it is preferable to contain a surface-modified metal oxide within the above range.

In addition, the organic solvent may have a dielectric constant of 20 or less, preferably 5 to 15. Specific examples of the organic solvent include isopropyl alcohol, butyl alcohol, 2-methoxy ethanol, ethyl acetate, and the like, and may be used alone or in combination as the organic solvent of the present invention. If a solvent having a dielectric constant higher than 20 is used, the attractive force between the SnO₂ particles and the polar solvent may be increased, thereby causing the SnO₂ particles to agglomerate (degrading dispersibility and dispersion stability), and in the process of forming the SnO₂ thin film, the perovskite material, which is the light absorption layer, may be decomposed in the polar solvent.

The surface-modified metal oxide nanoparticles may be prepared by performing a process including a first step of preparing metal oxide nanoparticles and a second step of react ing the metal oxide with a compound represented by the following Formula 1 to prepare surface-modified metal oxide nanoparticles. 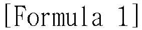 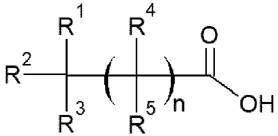 In Formula 1, R¹ to R⁵ are independent ly a hydrogen atom or a halogen atom, preferably a halogen atom, and more preferably -F. And, n is 0 to 5, preferably 0 to 3, and more preferably 0 to 2.

More specifically, the first step may be prepared by performing a process including the steps of: first-1 mixing a metal precursor and ultrapure water to prepare a metal precursor solution; first-2 adding a basic aqueous solution to the metal precursor solution to prepare a reaction solution; and first-3 performing hydrothermal synthesis on the reaction solution and obtaining metal oxide nanoparticles from the hydrothermal synthesis product.

In the method of preparing surface-modified metal oxide nanoparticles, the metal precursor solution of step first-1 may include a metal precursor and ultrapure water, and the concentration of the metal precursor in the metal precursor solution may be 0.15 to 0.70 M, preferably 0.16 to 0.50 M. In this case, if the metal precursor concentration in the metal precursor solution is less than 0.15 M, the metal oxide nanoparticle yield may be too small, and if the metal precursor concentration in the metal precursor solution is greater than 0.7 M, the viscosity of the metal precursor aqueous solution increases, and thus, there may be a problem in that the metal oxide nanoparticles are unevenly formed when prepared under the same process conditions, and thus uniform nanoparticles cannot be obtained.

In the method of preparing surface-modified metal oxide nanoparticles, the basic aqueous solution of step first-2 may include at least one selected from a KOH aqueous solution, a NaOH aqueous solution, a hydrazine aqueous solution, and a NH₄OH aqueous solution. In addition, the amount of the basic aqueous solution used is added to the metal precursor solution such that the pH of the reaction solution is about 8.0 or higher, preferably about 8.0 to 9.0, and more preferably about 8.2 to 8.8, and in this case, if the pH is less than 8, the metal oxide nanoparticle yield may be too small, and further, the metal precursor solution may be gelled and stirring may not be good, and if the pH is too high, the particle diameter of the metal oxide particles may be too large.

In the method of preparing surface-modified metal oxide nanoparticles, the hydrothermal synthesis of step first-3 may be performed by applying a general hydrothermal synthesis method used in the art, and the hydrothermal synthesis may be performed at 100 to 200 °C, preferably at 120 to 190 °C, and more preferably at 140 to 180 °C for 6 to 48 hours, preferably 10 to 24 hours, and more preferably 12 to 18 hours. In this case, if the hydrothermal synthesis temperature is less than 100°C, the crystallinity of the metal oxide may be low, and if the temperature is more than 200 °C, the size of the metal oxide particles may be increased. In addition, if the hydrothermal synthesis time is less than 6 hours, the yield of the metal oxide nanoparticles may be too deteriorated, and if the time is more than 48 hours, the size of the hydrothermal synthesis product may be too large, and thus, the hydrothermal synthesis may be performed within the above time.

The metal oxide nanoparticles obtained through the hydrothermal synthesis may be repeatedly washed 3 to 5 times using ultrapure water and ethanol.

The metal oxide nanoparticles obtained in this way may have an average particle diameter of 2 to 10 nm, preferably an average particle diameter of 2 to 8 nm, and more preferably an average particle diameter of 3 to 5 nm.

And, the metal oxide of the metal oxide nanoparticles may be an oxide of a metal including one or two or more selected from tin (Sn), titanium (Ti), zinc (Zn), cerium (Ce), zirconium (Zr), strontium (Sr), zinc (Zn), vanadium (V), molybdenum (Mo), tungsten (W), niobium (Nb), aluminum (Al), and gallium (Ga), and in one embodiment, the metal oxide may include SnO₂, TiO₂, ZnO, CeOz and/or Zn₂SnO₄, and the like, and preferably may include SnO₂ and/or ZnO.

In the method of preparing surface-modified metal oxide nanoparticles, the second step may perform a process of modifying the surface of the metal oxide nanoparticles obtained in the first step, the process including the steps of: second-1 mixing the metal oxide nanoparticles and ultrapure water to prepare a solution; second-2 adding the compound represented by Formula 1 to the solution to prepare a reaction solution; second-3 performing a reflux reaction of the reaction solution; second-4 separating a reaction product from the solution subjected to the reflux reaction and washing the separated reaction product; and second-5 drying the washed reaction product to obtain surface-modified metal oxide nanoparticles.

The reaction solution may contain 100 to 700 parts by weight of ultrapure water and 300 to 1,500 parts by weight of the compound represented by Formula 1 based on 100 parts by weight of the metal oxide nanoparticles, preferably 350 to 600 parts by weight of ultrapure water and 400 to 1,200 parts by weight of the compound based on 100 parts by weight of the metal oxide nanoparticles, and more preferably 350 to 550 parts by weight of ultrapure water and 450 to 850 parts by weight of the compound. In this case, if the amount of ultrapure water is less than 100 parts by weight, there may be a problem in that the reflux of the solvent is not sufficiently performed during the surface modification process and thus the surface modification is not evenly performed, and if the amount of ultrapure water is more than 700 parts by weight, there may be a problem in that the reflux reaction time is too long. And, if the amount of the compound is less than 300 parts by weight, there may be a problem in that the degree of modification of the metal oxide surface is excessively insufficient or uneven to cause the metal oxide particles to be precipitated without being evenly dispersed in a solvent, and if the amount of the compound is more than 1,500 parts by weight, there may be a problem in that it is not economical, and rather, the device characteristics of the solar cell are deteriorated due to the unreacted compound, and thus it is preferable to use it within the above range.

The reflux reaction in step second-3 can be performed at 80 to 140 °C, preferably at 80 to 120 °C, and in this case, if the reflux reaction temperature is less than 80 °C, there may be a problem in that reflux is not sufficiently performed, and if the reflux reaction temperature is greater than 140 °C, there may be a problem in that the metal oxide surface is too much modified to inhibit driving of the solar cell device. Further, the reflux reaction time is appropriately about 1 to 4 hours, preferably about 1.5 to 3 hours.

The separating and/or washing of step second-4 may be performed by a general method used in the art, and in one embodiment, the separating and/or washing may be performed by performing centrifugation to obtain a reflux reaction product from a reaction solution, and then washing it with ultrapure water or the like.

The drying of steps 2-5 may be performed by a general method used in the art, and in one embodiment, the reaction product obtained by washing may be performed by applying heat in an oven at 50 to 80 °C.

The above-described coating agent for forming the electron transporting layer may be coated by a general coat ing method such as spin coating, blade coating, bar coating, spray coating, gravure coating, die coating, etc., and in one embodiment, after coating, an ultra-thin film having a thickness of 100 nm or less, preferably 1 to 40 nm, more preferably 1 to 20 nm may be formed by heat treatment at 200 °C or less.

In the method for manufacturing the perovskite solar cell of the present invention, as for the laminate of the first step, a drain electrode may be formed on a conductive substrate, and then the previously described hole transport layer, perovskite light absorption layer, and electron transporting layer may be sequentially formed on the drain electrode.

In this case, the conductive substrate may use a general conductive substrate used in the art, and for example, a transparent plastic substrate, a glass substrate, a quartz substrate, a silicon substrate, or the like made of a material such as polyethylene terephthalate, polyethylene naphthalate, polyethersulfone, aromatic polyester, or polyimide may be used.

The drain electrode may be made of a material including at least one selected from a conductive metal, an alloy of a conductive metal, a metal oxide, and a conductive polymer, and for example, preferably may include Indium Tin Oxide (ITO), Fluorine doped Tin Oxide (FTO), Sb₂O₃ doped Tin Oxide (ATO), Gallium doped Tin Oxide (GTO), tin doped zinc oxide (ZTO), ZTO:Ga (gallium doped ZTO), Indium gallium zinc oxide (IGZO), Indium doped zinc oxide (IZO), Aluminum doped zinc oxide (AZO), and/or the like.

The thickness of the electron transporting layer formed in the first step may be 100 nm or less, preferably 1 to 40 nm, more preferably 1 to 20 nm, and in this case, if the thickness of the electron transporting layer exceeds 100 nm, there may be a problem in that a short-circuit current (Jsc) and an open-circuit voltage (Voc) of the solar cell decrease, and thus the thickness may be formed within the above range.

The roughness of the thus-formed coating layer, that is, the surface of the electron transporting layer may be formed to be very low, and the root-mean-square (RMS) roughness may be 25 nm or less, preferably 17.0 to 25.0 nm, more preferably 17.5 to 24.0 nm.

Next, in the method for manufacturing the perovskite solar cell of the present invention, the second step is a process of forming a transparent thin film conductive barrier layer through a deposition process on top of the electron transporting layer, and the conductive barrier layer may be a transparent thin film deposited with ITO (indium tin oxide), FTO (fluorine doped tin oxide), ATO (Sb₂O₃ doped tin oxide), GTO (gallium doped tin oxide), ZTO (tin doped zinc oxide), ZTO:Ga (gallium doped ZTO), IGZO (indium gallium zinc oxide), IZO (indium doped zinc oxide), or AZO (aluminum doped zinc oxide).

In this case, the deposition may be performed by a general deposition process used in the art, and preferably, the deposition process may be performed using a sputtering method at a process temperature of 100 °C or less under the conditions of RF power of 100 to 300 W, process pressure of 1 to 3 mTorr, and argon (Ar) flow of 10 to 40 sccm.

Additionally, the surface of the conductive barrier layer may satisfy an RMS roughness of 30 nm or less, preferably 17.5 to 27.0 nm, and more preferably 18.0 to 25.0 nm.

Additionally, the conductive barrier layer may have a low sheet resistance of 80 Ω/sq or less, preferably 76 Ω/sq or less, and more preferably 30.0 to 70 Ω/sq.

The conductive barrier layer formed in the second step may have an average thickness of 50 to 110 nm, preferably an average thickness of 55 to 105 nm, and more preferably an average thickness of 60 to 100 nm. In this case, if the average thickness of the conductive barrier layer is less than 50 nm, the thickness is too thin, and thus the effect of preventing electrode penetration and ion migration due to the introduction of the conductive barrier layer may be minimal or non-existent, and sheet resistance increases, causing a problem of reduced device performance. In addition, if the average thickness of the conductive barrier layer exceeds 110 nm, as sheet resistance decreases, charge movement becomes smoother, which is advantageous for device operation, however, as the process time increases, damage to the light absorption layer may occur and productivity may decrease, and in the case of a tandem device, since the light receiving direction passes through the conductive barrier layer and reaches the perovskite photoactive layer, unnecessary photocurrent loss may occur due to the thick conductive barrier layer, so it is recommended to form the conductive barrier layer by performing a deposition process to have an average thickness in the above range.

Next, in the method for manufacturing the perovskite solar cell of the present invention, the third step is a process of forming a source electrode on the conductive barrier layer formed in the second step, and the source electrode may be formed by coating or depositing at least one material selected from Pt, Au, Ni, Cu, Ag, In, Ru, Pd, Rh, Ir, Os, C, and a conductive polymer.

In addition, the source electrode of the solar cell configuration of the present invention may be formed by coating or depositing at least one material selected from Pt, Au, Ni, Cu, Ag, In, Ru, Pd, Rh, Ir, Os, C and a conductive polymer.

In addition, the solar cell of the present invention may further include a passivation layer between the light absorption layer and the electron transporting layer.

Hereinafter, the present invent ion will be described in more detail through the following examples, but the following examples are not intended to limit the scope of the present invention, which should be construed to aid understanding of the present invention.

### [Examples]

### Example 1: Preparation of a coating solution for forming an electron transporting layer (ETL)

### (1) Preparation of SnO₂ nanoparticles

SnCl₄·5H₂O was added to a beaker containing ultrapure water and stirred to prepare a metal precursor solution having a SnCl₄ concentration of 0.33 M, and then 35 ml of a basic aqueous solution NH₄OH was added to 265 ml of the metal precursor solution to prepare a reaction solution having a pH of about 8.0 to 8.5 of the aqueous solution.

The reactive solution was put into a pressure vessel (autoclave or hydrothermal reactor) and hydrothermal synthesis was performed at 180 °C for 12 hours.

Next, the product obtained through hydrothermal synthesis was washed three to five times using ultrapure water and ethanol to prepare SnO₂ nanoparticles.

The average particle diameter of the prepared SnO₂ nanoparticles was 3 to 5 nm.

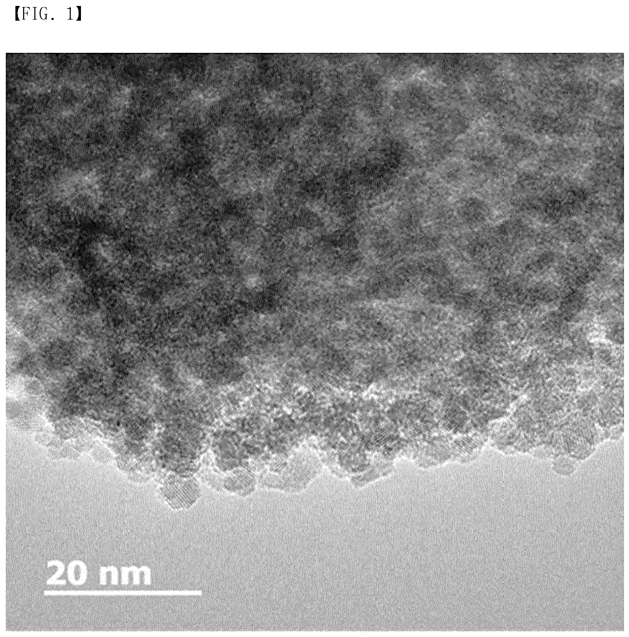

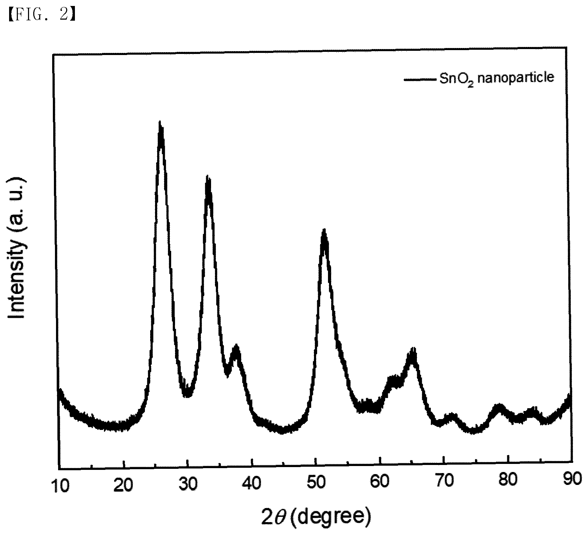

Further, TEM measurement images of the prepared SnO₂ nanoparticles are shown in FIG. 1, and XRD measurement results are shown in FIG. 2.

### (2) Preparation of surface-modified SnO₂ nanoparticles

8 g of the previously prepared SnO₂ nanoparticles were added to a round bottom flask containing 40 mL of ultrapure water and stirred, and then 54 g of TFA (trifluoroacetic acid) was added to prepare a reaction solution. A condenser was mounted on a round bottom flask containing the prepared reaction solution, and a reflux reaction was performed at 90 °C for 2 hours.

Next, the nanoparticles were separated from the reaction solution subjected to the reflux reaction by using a centrifuge and then dried in an oven at 60 °C to prepare surface-modified SnOz nanoparticles.

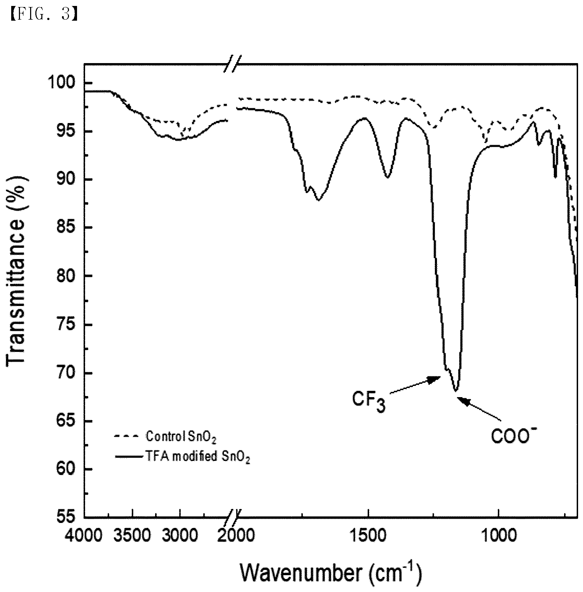

Further, FT-IR measurement results of the prepared surface-modified SnO₂ nanoparticles are shown in FIG. 3.

### (3) Preparation of a dispersion solution (coating solution) of surface-modified SnO₂ nanoparticles

30 mg of the previously prepared surface-modified SnO₂ nanoparticles were added to 4 ml of low polarity isopropyl alcohol (dielectric constant ≤ 20), and then a coating solution for forming an electron transporting layer having a dispersion solution type (about 0.74 wt % of surface-modified metal oxide) was prepared using an ultrasonic crusher.

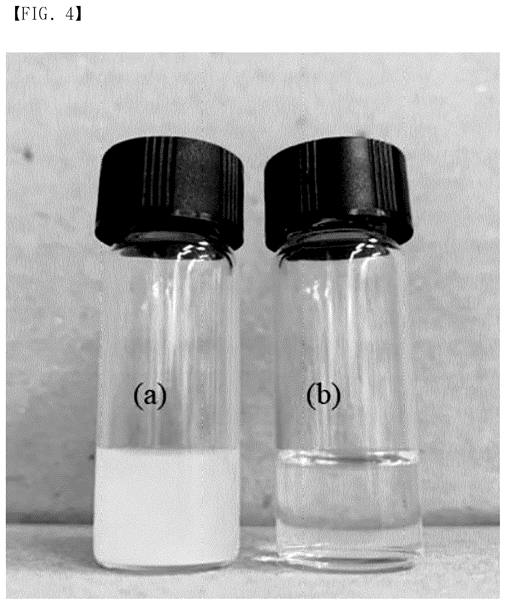

Further, a photograph of the coating solution for forming an electron transporting layer having a dispersion solution type is shown in FIG. 4(b), and FIG. 4(a) is a photograph after 30 mg of the surface-modified SnO₂ nanoparticles were added to isopropyl alcohol and dispersed using an ultrasonic crusher.

### Comparative Example 1

The SnO₂ nanoparticles prepared in (1) of Example 1 were prepared without a surface modification process.

Further, 30 mg of the SnO₂ nanoparticles without surface modification were added to 4 ml of isopropyl alcohol, and then a coating solution for forming an electron transporting layer having a dispersion solution type was prepared using an ultrasonic crusher. A photograph of the prepared coating solution is shown in FIG. 4(a).

### Examples 2 to 3 and Comparative Examples 2 to 3

Examples 2 to 3 and Comparative Examples 2 to 3 were performed by preparing a coating solution for forming an electron transporting layer in the same manner as in Example 1, except that surface-modified SnOz nanoparticles having a composition as shown in Table 1 below were prepared, the surface-modified SnO₂ nanoparticles were mixed with an organic solvent, and then a coating solution for forming an electron transporting layer of a dispersion solution type was prepared using an ultrasonic crusher, respectively.

### Comparative Example 4

Comparative Example 4 was performed by preparing a coating solution for forming an electron transporting layer in the same manner as in Example 1, except that the surface-modified SnO₂ nanoparticles of Example 1 were mixed with ethyl alcohol having a dielectric constant of 25, and then a coating solution for forming an electron transporting layer of a dispersion solution type was prepared using an ultrasonic crusher, respectively.

**[Table 1]**

| Classification | Surface-modified SnO₂ nanoparticles | | | | Organic solvent |
|---|---|---|---|---|---|
| | SnO₂ nanoparticles | | Ultrapure water | TFA | |
| | Amount used | Average particle diameter | Amount used | Amount used | |
| Example 1 | 100 parts by weight (8g) | 3 - 5 nm | 500 parts by weight (40 ml) | 675 parts by weight (54g) | Isopropyl alcohol |
| Example 2 | 100 parts by weight | 3 - 5 nm | 500 parts by weight | 350 parts by weight | Isopropyl alcohol |
| Example 3 | 100 parts by weight | 3 - 5 nm | 500 parts by weight | 1,350 parts by weight | Isopropyl alcohol |
| Comparative Example 1 | 100 parts by weight | 3 - 5 nm | - | - | Isopropyl alcohol |
| Comparative Example 2 | 100 parts by weight | 3 - 5 nm | 500 parts by weight | 270 parts by weight | Isopropyl alcohol |
| Comparative Example 3 | 100 parts by weight | 3 - 5 nm | 500 parts by weight | 1570 parts by weight | Isopropyl alcohol |
| Comparative Example 4 | 100 parts by weight | 3 - 5 nm | 500 parts by weight | 675 parts by weight | Ethyl alcohol |

### Experimental Example 1: Ultra-thin film preparation and coating layer surface roughness and light transmittance measurement

Each of the coating solutions prepared in the Examples and Comparative Examples was spin-coated on top of a perovskite thin film including a glass substrate and a glass substrate, and then heat-treated at 30 °C , thereby preparing an ultra-thin film having a thickness of 20 nm.

In addition, the surface roughness of the ultra-thin film (electron transporting layer) formed on top of the perovskite thin film including the glass substrate was measured by a non-contact method, and then calculated as root-mean-square (RMS) of the roughness, and the surface roughness of any 3 points was measured, and then the average value of the measured surface roughness of the 3 points is shown in Table 2 below.

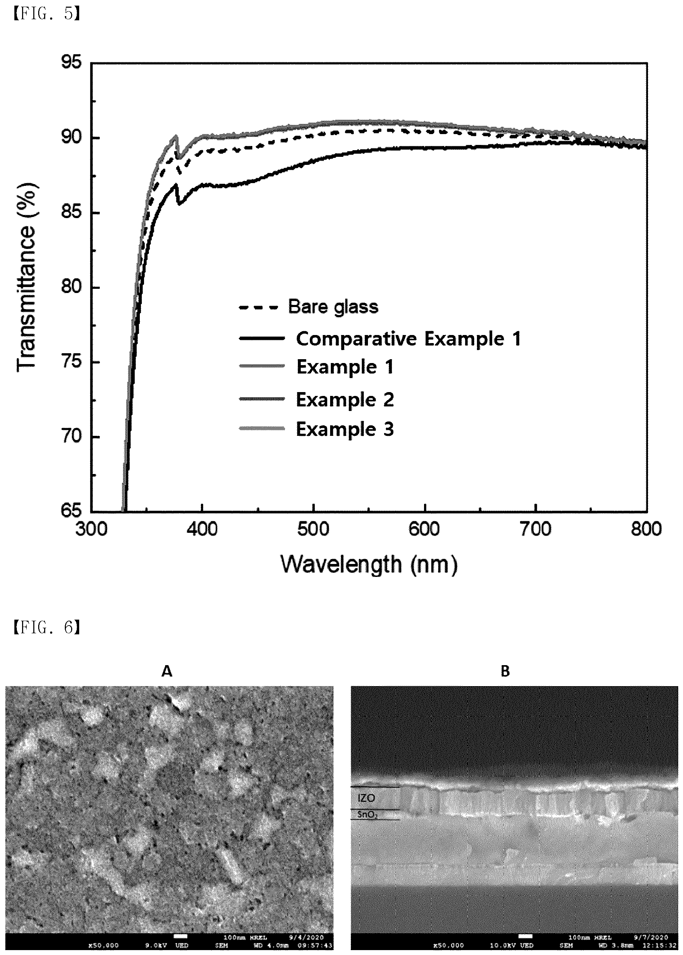

In addition, the ultra-thin film formed on the glass substrate was scanned with near-infrared rays by a UV spectrum measurement method onto the substrate on which the ultra-thin film was formed to measure the absorbance and light transmittance (%) of the sample, and the results are shown in Table 2 below, and the results of measuring the light transmittance of Example 1 are shown in FIG. 5. In this case, the light transmittance is a light transmittance at a wavelength of 500 to 550 nm.

**[Table 2]**

| Classification | RMS (root-mean-square) roughness | Light transmittance (%) |
|---|---|---|
| Example 1 | 19.8 nm | 91.1% |
| Example 2 | 21.5 nm | 90.9% |
| Example 3 | 22.7 nm | 91.0% |
| Comparative Example 1 | 71.4 nm | 88.9% |
| Comparative Example 2 | 35.7 nm | 89.3% |
| Comparative Example 3 | 24.8 nm | 90.2% |
| Comparative Example 4 | Not measurable | Not measurable |

Referring to the RMS roughness and the light transmittance of Table 2, in the case of Examples 1 to 3, it was confirmed that the RMS roughness was 18.0 to 23.0 nm, which is very low surface roughness, and excellent optical properties of light transmittance of 90% or more were achieved.

On the other hand, in the case of Comparative Example 2, which is a coating solution using surface-modified SnO₂ nanoparticles prepared using only 270 parts by weight of less than 300 parts by weight of TFA when synthesizing surface-modified SnO₂ nanoparticles, compared to Example 1 or Example 2, there was a problem in that not only the light transmittance was low, but also the roughness was relatively high, and the surface-modified SnO₂ nanoparticles were not evenly dispersed. And, in the case of Comparative Example 3, which uses 1570 parts by weight of more than 1500 parts by weight of TFA, compared to Example 3, there was a part where the roughness increased and the light transmittance was partially lowered, which is considered to be due to agglomeration between some of the surface-modified SnO₂ nanoparticles.

And, in the case of Comparative Example 4, there was a problem in that since the SnO₂ particles were not dispersed, the agglomerated particles were coated in the form of islands on top of the glass substrate, so that a thin film could not be formed.

### Preparation Example 1: Preparation of an inverted-structure perovskite solar cell

As a drain electrode, an organic substrate (thickness 1.1 mm, 15.0 Ω/sq) coated with indium tin oxide (ITO) having a thickness of about 110 nm was sequentially washed with acetone and isopropyl alcohol (IPA) by using an ultrasonic cleaner for 1 hour, respectively.

Next, a hole transport layer (NiOₓ) having a thickness of 30 nm was formed on the drain electrode under the conditions of an E-beam vacuum deposition method.

Next, a yellow light absorption layer solution formed by dissolving in dimethylformamide (DMF) and dimethyl sulfoxide (DMSO) was formed on top of the hole transport layer by spin coating, and heat-treated at 100 °C for 20 minutes to form a NiOx hole transport layer and a light absorption layer (CsMAFAPbIₓBr₃₋ₓ (0 ≤ x ≤ 3)) having a perovskite crystal structure of 450 to 500 nm thick.

Next, the surface-modified coating solution prepared in Example 1 was spin-coated on top of the perovskite light absorption layer at 1,500 rpm for 1 minute, and then heat-treated at 30 °C to form an electron transport ing layer having an average thickness of 20 nm.

Next, a stuttering process (process conditions: process temperature 95 to 98 °C, RF power 200 to 250 W, process pressure 2.2 to 2.4 mTorr, argon flow rate 25 to 30 sccm) was performed with IZO (Indium doped zinc oxide) on top of the electron transporting layer to form a transparent deposited thin film (conductive barrier layer) with an average thickness of 88 nm.

Next, by depositing silver (Ag) on top of the conductive barrier layer to a thickness of 100 nm at a pressure of 1 × 10⁻⁷ torr to form a source electrode, an inverted-structure perovskite solar cell having a shape in which the drain electrode, hole transport layer, light absorption layer, electron transporting layer, conductive barrier layer, and source electrode were sequentially stacked was prepared.

And, the RMS of the surface of the electron transporting layer of the prepared solar cell was about 19.2 nm, and the RMS of the surface of the conductive barrier layer was about 23.4 nm.

In addition, SEM measurement images of the surface of the electron transporting layer of the prepared solar cell and the cross-sectional structure of the solar cell are shown in A and B of FIG. 6.

### Comparative Preparation Example 1

A drain electrode, a hole transport layer, and a perovskite light absorption layer were formed in the same manner as Preparation Example 1.

Next, a passivation layer (C₆₀) having a thickness of 13 nm was formed on top of the light absorption layer under the conditions of thermal evaporation.

Next, the surface-modified coating solution prepared in Example 1 was spin-coated on top of the conductive barrier layer at 1,500 rpm for 1 minute, and then heat-treated at 30 °C to form an electron transporting layer having a thickness of 20 nm.

Next, by depositing silver (Ag) on top of the conductive barrier layer to a thickness of 100 nm at a pressure of 1 × 10⁻⁷ torr to form a source electrode, an inverted-structure perovskite solar cell having a shape in which the drain electrode, hole transport layer, light absorption layer, passivation layer(C₆₀), electron transporting layer, and source electrode were sequentially stacked was prepared.

And, the RMS of the surface of the electron transporting layer of the prepared solar cell was about 20.0 nm.

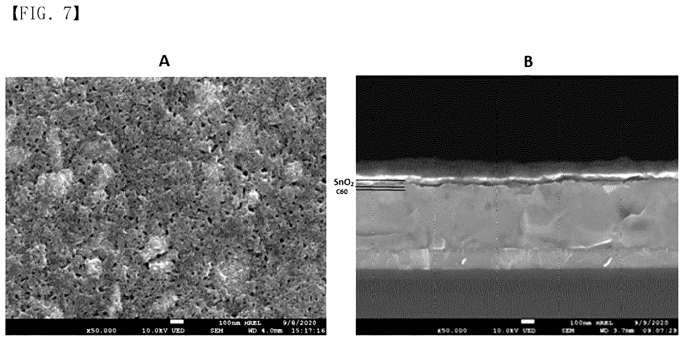

In addition, SEM measurement images of the surface of the electron transporting layer of the prepared solar cell and the cross-sectional structure of the solar cell are shown in A and B of FIG. 7.

### Preparation Examples 2 - 6 and Comparative Preparation Examples 2 - 4

Preparation Examples 2 to 6 and Comparative Preparation Examples 2 to 4 were each performed, by preparing the inverted-structure perovskite solar cells in the same manner as in Preparation Example 1, except that when forming an electron transporting layer, each of the solar cells in which the electron transporting layer was formed was prepared using each of the coating agents of Examples 2 to 3 and Comparative Example 1 instead of the coating agent of Example 1.

### Experimental Example 2: Performance measurement of a solar cell

The current-voltage characteristics and efficiency of the solar cell prepared in the Preparation Example 1 were measured, and the results are shown in Table 3 below.

**[Table 3]**

| Classifi cation | Electro n transpo rting layer | Passiv ation layer | Conductive barrier layer | | | Open-ci rcuit voltage (V_{oc}, V) | Short-c ircuit current density (J_{sc}, mA/cm² ) | Fill facto r (FF) | Photoel ectric convers ion efficie ncy (%) |
|---|---|---|---|---|---|---|---|---|---|
| | | | Type | Thick ness (nm) | Sheet resis tance (Ω/sq ) | | | | |
| Preparat ion Example 1 | Example 1 | Format ion × | IZO | 88 | 60.1 | 1.04 | 20.83 | 64.26 | 13.48 |
| Preparat ion Example 2 | Example 2 | Format ion × | IZO | 88 | 61.5 | 1.04 | 18.98 | 63.82 | 12.59 |
| Preparat ion Example 3 | Example 3 | Format ion × | IZO | 88 | 58.0 | 0.98 | 19.58 | 58.52 | 11.27 |
| Preparat ion Example 4 | Example 1 | Format ion × | IZO | 55 | 76.2 | 0.88 | 19.73 | 43.17 | 7.47 |
| Preparat ion Example 5 | Example 1 | Format ion × | IZO | 105 | 38.9 | 0.94 | 20.98 | 65.65 | 12.94 |
| Preparat ion Example 6 | Example 1 | Format ion × | ITO | 88 | 59.8 | 0.95 | 21.12 | 65.55 | 13.13 |
| Comparat ive Preparat ion Example 1 | Example 1 | C₆₀ | Forma tion × | - | - | 0.97 | 21.48 | 60.01 | 12.53 |
| Comparat ive Preparat ion Example 2 | Compara tive Example 1 | Format ion × | IZO | - | - | Not measura ble | Not measura ble | Not measu rable | Not measura ble |
| Comparat ive Preparat ion Example 3 | Example 1 | Format ion × | IZO | 48 | 88.6 | 0.90 | 18.41 | 31.54 | 5.24 |
| Comparat ive Preparat ion Example 4 | Example 1 | Format ion × | IZO | 112 | 34.1 | 0.95 | 20.00 | 67.08 | 12.71 |

Referring to the current-voltage characteristics and efficiency measurement results of the solar cells in Table 3 above, Preparation Examples 1 to 6 and Comparative Preparation Examples 1 to 2 showed a high fill factor of 42.0 FF or more and a photoelectric conversion efficiency of 7.0% or more, preferably a fill factor of 58 to 70 FF and a high photoelectric conversion efficiency of 11.0% to 14.0%.

And, in the case of Comparative Preparation Example 3 in which the conductive barrier layer was formed to 48 nm, which is less than 50 nm, when compared to Preparation Example 1 (88 nm) and Preparation Example 4 (55 nm), it was confirmed that there was a problem with a significant decrease in fill factor and photoelectric conversion efficiency, and this was because the sheet resistance greatly increased, impeding the movement of electrons collected in the electron transporting layer, thereby significantly reducing device efficiency.

In addition, in the case of Comparative Preparation Example 4 in which the conductive barrier layer was formed to 112 nm, which exceeds 110 nm, when compared to Preparation Example 1 (88 nm) and Preparation Example 5 (105 nm), although the sheet resistance was significantly low, the result showed no effect of increasing the fill factor and photoelectric conversion efficiency, but showed rather a decrease, and this is judged because when forming the conductive barrier layer, the process time or energy is increased to improve the thickness, which causes loss of the perovskite light absorption layer and photocurrent loss occurs due to unnecessary thickness.

### Experimental Example 3: Measurement of long-term storage stability of solar cells

The photoelectric conversion efficiency of each of the solar cells of Preparation Example 1 and Comparative Preparation Example 1 was measured as performed in Experimental Example 2, and left in a laboratory atmosphere at 25-28 °C and atmospheric pressure, and then the photoelectric conversion efficiency was measured once a day, and the photoelectric conversion efficiency measurement results after 14 days are shown in Table 4 below.

**[Table 4]**

| Classification | Electron transporting layer | Passivation layer | Conductive barrier layer | Photoelectric conversion efficiency (%) | | |
|---|---|---|---|---|---|---|
| | | | | Day 1 | Day 14 | Reduction ratio |
| Preparation Example 1 | Example 1 | × | IZO | 13.48 | 12.72 | 5.6% |
| Comparative Preparation Example 1 | Example 1 | C₆₀ | × | 12.53 | 9.10 | 27.4% |

Referring to the photoelectric conversion efficiency measurement results in Table 4 above, in the case of Comparative Preparation Example 1 in which a passivation layer was formed between the photoactive layer and the electron transport layer, the photoelectric conversion efficiency (%) decreased by about 27.4%, resulting in poor long-term storage stability, but in comparison, it was confirmed that the solar cell of Preparation Example 1, in which a conductive barrier layer is formed between the electron transporting layer and the source electrode without forming a passivation layer between the photoactive layer and the electron transporting layer, has a very low photoelectric conversion efficiency reduction rate of 5.6%, and so through this, it was confirmed that the present invention has superior long-term storage stability compared to existing solar cells.

### Preparation Example 7: Preparation of a tandem-structure perovskite solar cell

To prepare a tandem solar cell, a silicon solar cell doped with n-type or p-type impurities as the lower solar cell was treated with hydrofluoric acid to remove the SiOₓ oxide film, and then the remaining hydrofluoric acid was removed using ultrapure water, and a thin recombination layer was formed on top of the silicon solar cell from which the oxide film was removed through a sputtering process.

Next, a hole transport layer (NiOₓ) having a thickness of 30 nm was formed on the silicon solar cell under the conditions of an E-beam vacuum deposition method.

Next, a yellow light absorption layer solution formed by dissolving in dimethylformamide (DMF) and dimethyl sulfoxide (DMSO) was formed on top of the hole transport layer by spin coating, and heat-treated at 100 °C for 20 minutes to form a NiOx hole transport layer and a light absorption layer (CSMAFAPbIₓBr₃₋ₓ (0 ≤ x ≤ 3)) having a perovskite crystal structure of 450 to 500 nm thick.

Next, the surface-modified coating solution prepared in Example 1 was spin-coated on top of the perovskite light absorption layer at 1,500 rpm for 1 minute, and then heat-treated at 30 °C to form an electron transporting layer having an average thickness of 20 nm.

Next, a stuttering process (process conditions: process temperature 95 to 98 °C, RF power 200 to 250 W, process pressure 2.2 to 2.4 mTorr, argon flow rate 25 to 30 sccm) was performed with IZO (Indium doped zinc oxide) on top of the electron transporting layer to form a transparent deposited thin film (conductive barrier layer) with an average thickness of 88 nm.

Next, by depositing silver (Ag) on top of the conductive barrier layer to a thickness of 100 nm at a pressure of 1 × 10⁻⁷ torr to form a source electrode, a tandem-structure perovskite solar cell having a shape in which the silicon solar cell, recombination layer, hole transport layer, light absorption layer, electron transporting layer, conductive barrier layer, and source electrode were sequentially stacked was prepared.

In the above, specific examples are shown and described. However, it is not limited to the above-described examples, and those skilled in the art can make various changes without departing from the gist of the technical idea of the invention as set forth in the claims below.

## Claims

1. A perovskite solar cell, comprising:
a laminate in which a hole transport layer, a perovskite light absorption layer, an electron transporting layer, and a source electrode are sequentially stacked,
wherein a conductive barrier layer is formed between the source electrode and the electron transporting layer, and
the electron transporting layer comprises surface-modified SnO₂ nanoparticles.

2. The perovskite solar cell of claim 1, wherein the conductive barrier layer is a transparent thin film deposited with ITO (indium tin oxide), FTO (fluorine doped tin oxide), ATO (Sb₂O₃ doped tin oxide), GTO (gallium doped tin oxide), ZTO (tin doped zinc oxide), ZTO:Gₐ (gallium doped ZTO), IGZO (indium gallium zinc oxide), IZO (indium doped zinc oxide), or AZO (aluminum doped zinc oxide).

3. The perovskite solar cell of claim 1, wherein the electron transporting layer has an average thickness of 100 nm or less, and the conductive barrier layer has an average thickness of 50 to 120 nm.

4. The perovskite solar cell of claim 1, wherein the electron transporting layer has a light transmittance of 88 to 95% for a wavelength of 500 to 550 nm when the electron transporting layer has a thickness of 20 to 30 nm.

5. The perovskite solar cell of claim 1,
wherein the surface of the electron transporting layer has a root-mean-square (RMS) roughness of 25 nm or less, and
the surface of the conductive barrier layer has an RMS roughness of 30 nm or less.

6. The perovskite solar cell according to one of claims 1 to 5, wherein the perovskite solar cell is a fin-structure perovskite solar cell, an inverted-structure perovskite solar cell, a tandem-type perovskite solar cell, or a tandem-type silicon/perovskite heterojunction solar cell.

7. The perovskite solar cell of claim 6, wherein the perovskite solar cell is an inverted-structure perovskite solar cell, and comprises a structure in which a drain electrode, a hole transport layer, a perovskite light absorption layer, an electron transporting layer, a conductive barrier layer, and a source electrode are sequentially stacked.

8. The perovskite solar cell of claim 6, wherein the perovskite solar cell is a tandem-type silicon/perovskite heterojunction solar cell, and comprises a structure in which a drain electrode, a silicon solar cell, a recombination layer, a hole transport layer, a perovskite light absorption layer, an electron transporting layer, a conductive barrier layer, and a source electrode are sequentially stacked.

9. A method for manufacturing a perovskite solar cell, comprising:
forming an electron transporting layer by coating a coating agent for forming an electron transporting layer on top of a perovskite light absorption layer of a laminate comprising a hole transport layer and a perovskite light absorption layer;
forming a transparent thin film conductive barrier layer on top of the electron transporting layer through a deposition process; and
forming a source electrode on top of the conductive barrier layer,
wherein the coating agent for forming an electron transporting layer comprises 0.50 to 3.00% by weight of surface-modified metal oxide and a remaining amount of an organic solvent.

10. The method for manufacturing a perovskite solar cell of claim 9, wherein the coating is performed by a solution coating process.
